# EUROPEAN PATENT SPECIFICATION

(11) **EP 3 560 000 B1**
(45) Date of publication and mention of the grant of the patent: **14.04.2021**
(21) Application number: 17835942.8
(22) Date of filing: 21.12.2017
(51) Int. Cl.: H01L 31/20, H01L 31/0392, H01L 31/048

(54) **ELECTRICALLY-CONDUCTIVE COPOLYESTERCARBONATE-BASED MATERIAL**
ELEKTRISCH LEITFÄHIGES AUF COPOLYESTERCARBONAT BASIERENDES MATERIAL
MATÉRIAU À BASE DE COPOLYESTERCARBONATE ÉLECTROCONDUCTEUR

(30) Priority: 23.12.2016 US 201662438734 P
(43) Date of publication of application: 30.10.2019
(73) Proprietor: SHPP Global Technologies B.V., 4612 PX Bergen op Zoom (NL)
(72) Inventor: HAUGER, Tate Carston, Edmonton Alberta T6C 1N3 (CA); BURIAK, Jillian Mary, Edmonton Alberta T6H 3T5 (CA); VOLLENBERG, Peter Hendrikus Theodorus, 6167 RD Geleen (NL)
(74) Representative: Elzaburu S.L.P.
(86) International application number: PCT/IB2017/058294
(87) International publication number: WO 2018/116245

(56) References cited:
- EP-A2- 0 793 277
- WO-A2-2011/143275
- US-A- 5 417 770
- US-A1- 2012 003 448
- US-A1- 2015 037 517
- US-B2- 6 583 256

## Description

### FIELD OF THE DISCLOSURE

The present disclosure generally relates to electrically conductive materials. More particularly, the disclosure relates to electrically-conductive copolyestercarbonate-based materials having particular performance characteristics.

### BACKGROUND OF THE DISCLOSURE

Conductive substrates in used today are predominantly formed of transparent conductive metal oxides (TCOs), such as indium-tin oxide (ITO), which may be combined with other oxides and then coated with a thin layer of glass or polyethylene terephthalate (PET). Such substrates are not suitable for applications that require enhanced flexibility and impact resistance, however. For such applications, one cost-effective manner to produce flexible electronics is known as the roll-to-roll (R2R) process, which is somewhat analogous to a newspaper printing line.

A drying step is typically included in the R2R process and is preferably performed at a temperature as high as possible to quickly and effectively remove solvents or dispersion liquids used for inks or other materials that are part of the various layers which make up the so-called flexible electronics "stack." PET has a relatively low glass transition temperature of 78 degrees Celsius (°C), however, which results in limitations in its use in manufacturing applications utilizing the R2R process.

Moreover, TCOs have limitations in terms of their flexibility. Various new conductive technologies have been developed which outperform TCOs in the R2R manufacturing process. Such conductive technologies include silver nano-wire (AgNW) and silver nano-mesh (AgNM) coatings, which have been applied to PET. In addition to being flexible, substrates including AgNW and AgNM have demonstrated good light transmission properties. The PET substrates currently in use suffer from poor glass transition temperature properties described above, however, limiting their usefulness in some applications.

US 2015/037517 describes methods for making conductive materials. The methods can be used to make transparent, opaque, or reflective electrodes by using the same materials and equipment but varying the processing conditions or amounts of materials used. The methods can include: (a) providing a substrate comprising a first surface and an opposite second surface, wherein micro- or nanostructures are disposed on at least a portion of the first surface, and wherein the first surface is not pre-conditioned to increase attachment between the micro- or nanostructures and the substrate; (b) applying heat to heat the substrate surface to a temperature that is greater than the glass transition temperature or the Vicat softening temperature of the substrate and less than the melting point of the substrate; (c) applying pressure such that the substrate and the micro- or nanostructures are pressed together; and (d) removing the pressure to obtain the conductive material.

WO 2011/143275 describes methods and devices for improved deposition systems. In one example, a deposition system is provided for use with a solution and a substrate. The system comprises of a solution deposition apparatus; at least one heating chamber; at least one assembly for holding a solution over the substrate; and a substrate curling apparatus for curling at least one edge of the substrate to define a zone capable of containing a volume of the solution over the substrate. In another embodiment, a deposition system for use with a substrate, the system comprising a solution deposition apparatus; at heating chamber; and at least assembly for holding solution over the substrate to allow for a depth of at least about 0.5 microns to 10 mm.

US 2012/003448 describes an assembly that includes a barrier film interposed between a first polymeric film substrate and a first major surface of a pressure sensitive adhesive layer. The first polymeric film substrate has a first coefficient of thermal expansion that is, in some embodiments, up to 50 parts per million per Kelvin. The pressure sensitive adhesive layer has a second major surface opposite the first major surface that is disposed on a second polymeric film substrate. The second polymeric film substrate is typically resistant to degradation by ultraviolet light. In some embodiments, the second polymeric film substrate has a second coefficient of thermal expansion that is at least 40 parts per million per Kelvin higher than the first coefficient of thermal expansion. The assembly is transmissive to visible and infrared light.

These and other shortcomings are addressed by aspects of the present disclosure.

### BRIEF DESCRIPTION OF THE FIGURES

In the drawings, which are not necessarily drawn to scale, like numerals may describe similar components in different views. Like numerals having different letter suffixes may represent different instances of similar components. The drawings illustrate generally, by way of example, but not by way of limitation, various aspects discussed in the present document.
FIG. 1 is a block diagram illustrating a method for making an electrically-conductive material according to an aspect of the disclosure.
FIG. 2 is a nanometer-scale image of the surface of a polymeric substrate according to an aspect of the disclosure.
FIGS. 3A and 3B are graphs of sheet resistance vs. time comparing prior art conductive materials to polymeric materials according to aspects of the present disclosure.

### SUMMARY

The invention is an electrically-conductive material as defined in claim 1 and its corresponding manufacturing method as defined in claim 10. Aspects of the disclosure relate to an electrically-conductive material including a polymeric substrate and a conductive nanostructured or microstructured material adhered to at least one surface of the polymeric substrate. The polymeric substrate includes a polymeric block copolyestercarbonate derived from resorcinol or alkylresorcinol isophthalate-terepthalate. The polymeric block copolyestercarbonate has a glass transition temperature of at least 130 degrees Celsius (°C) and a sheet resistance of less than 20 ohms (Ω) per square (sq).

Further aspects of the disclosure relate to a method for making an electrically-conductive material, the method including: applying a conductive nanostructured or microstructured material onto at least one surface of a polymeric substrate; heating the at least one surface of the polymeric substrate to a temperature that is greater than the glass transition temperature of the polymeric substrate; and applying pressure to the conductive nanostructured or microstructured material and the at least one surface to adhere the conductive nanostructured or microstructured material to the at least one surface. The polymeric substrate has a glass transition temperature of at least 130 °C. The polymeric substrate includes a polymeric block copolyestercarbonate derived from resorcinol or alkylresorcinol isophthalate-terepthalate and has a sheet resistance of less than 20 ohms (Ω) per square (sq).

### DETAILED DESCRIPTION

The present disclosure can be understood more readily by reference to the following detailed description of the disclosure and the Examples included therein. In various aspects, the present disclosure pertains to electrically-conductive material including a polymeric substrate and a conductive nanostructured or microstructured material adhered to at least one surface of the polymeric substrate. The polymeric substrate includes a polymeric block copolyestercarbonate derived from resorcinol or alkylresorcinol isophthalate-terepthalate. The polymeric block copolyestercarbonate has a glass transition temperature of at least 130 degrees Celsius (°C) and a sheet resistance of less than 20 ohms (Ω) per square (sq). In an aspect, the electrically-conductive material exhibits improved properties, including but not limited to one or more of inherent ultraviolet resistance, transparency, light transmission properties, chemical resistance and/or sheet resistance.

Before the present compounds, compositions, articles, systems, devices, and/or methods are disclosed and described, it is to be understood that they are not limited to specific synthetic methods unless otherwise specified, or to particular reagents unless otherwise specified, as such can, of course, vary. It is also to be understood that the terminology used herein is for the purpose of describing particular aspects only and is not intended to be limiting.

Various combinations of elements of this disclosure are encompassed by this disclosure, e.g., combinations of elements from dependent claims that depend upon the same independent claim.

Moreover, it is to be understood that unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that an order be inferred, in any respect. This holds for any possible non-express basis for interpretation, including: matters of logic with respect to arrangement of steps or operational flow; plain meaning derived from grammatical organization or punctuation; and the number or type of aspects described in the specification.

All publications mentioned herein disclose and describe the methods and/or materials in connection with which the publications are cited.

### Definitions

It is also to be understood that the terminology used herein is for the purpose of describing particular aspects only and is not intended to be limiting. As used in the specification and in the claims, the term "comprising" can include the aspects "consisting of' and "consisting essentially of." Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

As used in the specification and the appended claims, the singular forms "a," "an" and "the" include plural referents unless the context clearly dictates otherwise. Thus, for example, reference to "a polyestercarbonate" includes mixtures of two or more polyestercarbonate polymers.

As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated ±10% variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the formulation or composition in which the component is included.

As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation are equal to 100.

Unless otherwise stated to the contrary herein, all test standards are the most recent standard in effect at the time of filing this application.

"Adhere" or "adhered" refers to the attachment or adhesion between the conductive nanostructured or microstructured material and the surface of the polymeric substrate. In certain aspects, and after employing the process of the present disclosure, the conductive nanostructured or microstructured material is sufficiently attached to the surface of the substrate such that it is conductive after being subjected to the Scotch tape test or the bending test or both. The scotch tap test consists of firmly pressing by hand scotch tape to the produced surface and then peeling off said Scotch tape. The bending test consists of bending the produced electrically-conductive material around a rod having a radius of about 0.625 millimeters (mm).

"Nanostructure" refers to an object or material in which at least one dimension of the object or material is equal to or less than 100 nanometers (nm) (e.g., one dimension is 1 to 100 nm in size). In a particular aspect, the nanostructure includes at least two dimensions that are equal to or less than 100 nm (e.g., a first dimension is 1 to 100 nm in size and a second dimension is 1 to 100 nm in size). In another aspect, the nanostructure includes three dimensions that are equal to or less than 100 nm (e.g., a first dimension is 1 to 100 nm in size, a second dimension is 1 to 100 nm in size, and a third dimension is 1 to 100 nm in size). The shape of the nanostructure can be of a wire, a particle, a sphere, a rod, a tetrapod, a hyperbranched structure, or mixtures thereof.

"Microstructure" refers to an object or material in which at least one dimension of the object or material is equal to or less than 1000 microns and greater than 100 nm (e.g., one dimension is greater than 100 nm and less than 1000 microns in size). In a particular aspect, the microstructure includes at least two dimensions that are equal to or less than 1000 microns and greater than 100 nm (e.g., a first dimension is greater than 100 nm and less than 1000 microns in size and a second dimension is greater than 100 nm and less than 1000 microns in size). In another aspect, the microstructure includes three dimensions that are equal to or less than 1000 microns and greater than 100 nm (e.g., a first dimension is greater than 100 nm and less than 1000 microns in size, a second dimension is greater than 100 nm and less than 1000 microns in size, and a third dimension is greater than 100 nm and less than 1000 microns in size). The shape of the microstructure can be of a wire, a particle, a sphere, a rod, a tetra-pod, a hyperbranched structure, or mixtures thereof.

The term "substantially" is defined as being largely but not necessarily wholly what is specified (and include wholly what is specified) as understood by one of ordinary skill in the art. In any disclosed aspect, the term "substantially" may be substituted with "within [a percentage] of' what is specified, where the percentage includes 0.1, 1, 5, and 10 percent.

Each of the materials disclosed herein are either commercially available and/or the methods for the production thereof are known to those of skill in the art.

It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

### Electrically Conductive Materials

Aspects of the disclosure relate to an electrically-conductive material including a polymeric substrate and a conductive nanostructured or microstructured material adhered to at least one surface of the polymeric substrate. The polymeric substrate includes a polymeric block copolyestercarbonate derived from resorcinol or alkylresorcinol isophthalate-terepthalate. In certain aspects the polymeric block copolyestercarbonate has a glass transition temperature of at least 130 degrees Celsius (°C) and has a sheet resistance of less than 20 ohms (Ω) per square (sq).

In some aspects the polymeric block copolyestercarbonate may be any of those copolyestercarbonates described in U.S. Patent No. 6,583,256, provided that the polymeric block copolyestercarbonate has a glass transition temperature of at least 130 degrees °C and has a sheet resistance of less than 20 Ω/sq as described herein. In particular aspects, the polymeric block copolyestercarbonate comprises organic carbonate blocks alternating with arylate blocks. Suitable block copolyestercarbonates include polymers comprising structural units of Formula I: 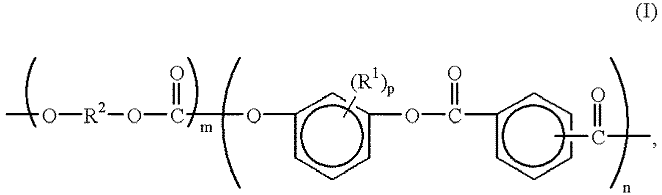 wherein each R¹ is independently halogen or C₁₋₁₂ alkyl, p is 0-3, each R² is independently a divalent organic radical, m is at least 1 and n is at least about 4. In some aspects n is at least about 10, or at least about 20, or about 30-150. In certain aspects m is at least about 3, or at least about 10, or about 20-200. In particular aspects m is between about 20 and 50. Within the context of the disclosure "alternating carbonate and arylate blocks" means that the copolyestercarbonates comprise at least one carbonate block and at least one arylate block.

The arylate blocks contain structural units comprising 1,3-dihydroxybenzene moieties which may be unsubstituted or substituted. Alkyl substituents, if present, may be straight-chain or branched alkyl groups, and are most often located in the ortho position to both oxygen atoms although other ring locations are contemplated. Suitable C₁₋₁₂ alkyl groups include methyl, ethyl, n-propyl, isopropyl, butyl, iso-butyl, t-butyl, nonyl, decyl, and aryl-substituted alkyl, including benzyl, with methyl being particularly preferred in some aspects. Suitable halogen substituents are bromo, chloro, and fluoro. 1,3-Dihydroxybenzene moieties containing a mixture of alkyl and halogen substituents are also suitable. The value for p may be 0-3, or 0-2, or even 0-1. One particular 1,3-dihydroxybenzene moiety is 2-methylresorcinol. A certain 1,3-dihydroxybenzene moiety is unsubstituted resorcinol in which p is zero. Polymers containing mixtures of 1,3-dihydroxybenzene moieties, such as a mixture of unsubstituted resorcinol with 2-methylresorcinol are also contemplated.

In the arylate structural units the 1,3-dihydroxybenzene moieties are bound to aromatic dicarboxylic acid moieties which may be monocyclic moieties, such as isophthalate or terephthalate or their chlorine-substituted derivatives; or polycyclic moieties, such as biphenyl dicarboxylate, diphenylether dicarboxylate, diphenylsulfone dicarboxylate, diphenylketone dicarboxylate, diphenylsulfide dicarboxylate, or naphthalenedicarboxylate, and in some aspects preferably naphthalene-2,6-dicarboxylate; or mixtures of monocyclic and/or polycyclic aromatic dicarboxylates. In some aspects the aromatic dicarboxylic acid moieties are isophthalate and/or terephthalate. Either or both of said moieties may be present. For the most part, both are present in a molar ratio of isophthalate to terephthalate in the range of about 0.25-4.0:1. When the isophthalate to terephthalate ratio is greater than about 4.0:1, then unacceptable levels of cyclic oligomer may form. When the isophthalate to terephthalate ratio is less than about 0.25:1, then unacceptable levels of insoluble polymer may form. Thus in some aspects the molar ratio of isophthalate to terephthalate is about 0.4-2.5:1, or from about 0.67-1.5:1.

In the carbonate blocks, each R² is independently an organic radical derived from a dihydroxy compound. For the most part, at least about 60 percent of the total number of R² groups in the polymer are aromatic organic radicals and the balance thereof are aliphatic, alicyclic, or aromatic radicals. Suitable R² radicals include m-phenylene, p-phenylene, 4,4'-biphenylene, 4,4'-bi(3,5-dimethyl)-phenylene, 2,2-bis(4-phenylene)propane and similar radicals such as those which correspond to the dihydroxy-substituted aromatic hydrocarbons disclosed by name or formula (generic or specific) in U.S. Patent No. 4,217,438, the disclosure of which is incorporated herein by this reference in its entirety. Included among suitable dihydroxy-substituted aromatic hydrocarbons are the 2,2,2',2'-tetrahydro-1,1'-spirobi[1H-indene]diols having Formula II: 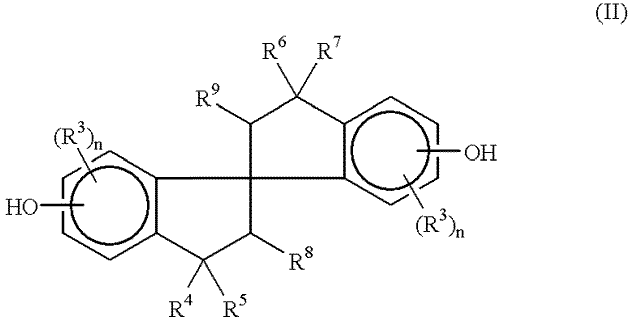 wherein each R³ is independently selected from monovalent hydrocarbon radicals and halogen radicals; each R⁴, R⁵, R⁶, and R⁷ is independently C₁₋₆ alkyl; each R⁸ and R⁹ is independently H or C₁₋₆ alkyl; and each n is independently selected from positive integers having a value of from 0 to 3 inclusive. A suitable 2,2,2',2'-tetrahydro-1,1'-spirobi[1H-indene]-diol is 2,2,2',2'-tetrahydro-3,3,3',3'-tetramethyl-1,1'-spirobi[1H-indene]-6,6'-diol.

In particular aspects, each R² is an aromatic organic radical, and even more particularly a radical of Formula III:

-A¹-Y-A²-, (III)

wherein each A¹ and A² is a monocyclic divalent aryl radical and Y is a bridging radical in which one or two carbon atoms separate A¹ and A². The free valence bonds in Formula III are usually in the meta or para positions of A¹ and A² in relation to Y. Compounds in which R² has Formula III are bisphenols, and for the sake of brevity the term "bisphenol" is sometimes used herein to designate the dihydroxy-substituted aromatic hydrocarbons; it should be understood, however, that non-bisphenol compounds of this type may also be employed as appropriate.

In Formula III, A¹ and A² typically represent unsubstituted phenylene or substituted derivatives thereof, illustrative substituents (one or more) being alkyl, alkenyl, and halogen (particularly bromine). Unsubstituted phenylene radicals are preferred in some aspects. Both A¹ and A² may be p-phenylene, although both may be o- or m-phenylene or one o- or m-phenylene and the other p-phenylene.

The bridging radical, Y, is one in which one or two atoms, separate A¹ from A². One suitable aspect is one in which one atom separates A¹ from A². Illustrative radicals of this type are -C=O, -O-, -S-, -SO- or -SO₂-, methylene, cyclohexylmethylene, 2-[2.2.1]-bicycloheptyl methylene, ethylene, isopropylidene, neopentylidene, cyclohexylidene, cyclopentadecylidene, cyclododecylidene, and adamantylidene.

Gem-alkylene radicals are often suitable. Also included, however, are unsaturated radicals. For reasons of availability and particular suitability for the purposes of the present disclosure, a particular bisphenol is 2,2-bis(4-hydroxy-phenyl)propane (hereinafter referred to as bisphenol A or BPA), in which Y is isopropylidene and A¹ and A² are each p-phenylene.

Depending upon whether or not any unreacted 1,3-dihydroxybenzene moiety is present in the reaction mixture as described hereinafter, R² in the carbonate blocks may consist of or at least partially comprise a radical derived from a 1,3-dihydroxybenzene moiety. Therefore, in one aspect the copolyestercarbonates comprise carbonate blocks with R² radicals derived from a dihydroxy compound identical to at least one 1,3-dihydroxybenzene moiety in the polyarylate blocks. In another aspect the copolyestercarbonates comprise carbonate blocks with R² radicals derived from a dihydroxy compound different from any 1,3-dihydroxybenzene moiety in the polyarylate blocks. In yet another aspect the copolyestercarbonates comprise carbonate blocks containing a mixture of R² radicals derived from dihydroxy compounds at least one of which is the same as and at least one of which is different from any 1,3-dihydroxybenzene moiety in the polyarylate blocks. When a mixture of R² radicals derived from dihydroxy compounds is present, then the molar ratio of dihydroxy compounds identical to those present in the polyarylate blocks to those dihydroxy compounds different from those present in the polyarylate blocks is typically about 1:999 to 999:1. In particular aspects the copolyestercarbonates comprise carbonate blocks containing a mixture of R² radicals derived from at least two of unsubstituted resorcinol, a substituted resorcinol, and bisphenol A.

Diblock, triblock, and multiblock copolyestercarbonates are encompassed in aspects of the present disclosure. The chemical linkages between blocks comprising arylate chain members and blocks comprising organic carbonate chain members typically comprise a carbonate linkage between a diphenol residue of an arylate moiety and a - C=O) -O- moiety of an organic carbonate moiety, although other types of linkages such as ester and/or anhydride are also possible. A typical carbonate linkage between said blocks is shown in Formula IV, wherein R¹ and p are as previously defined:

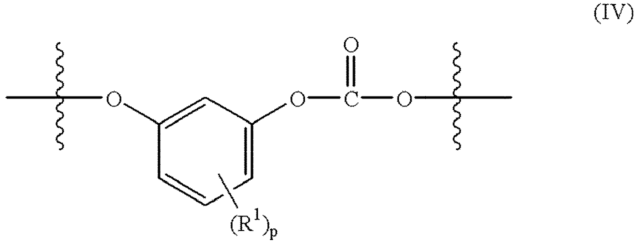

In one aspect the copolyestercarbonate is substantially comprised of a diblock copolymer with a carbonate linkage between an arylate block and an organic carbonate block. In another aspect the copolyestercarbonate is substantially comprised of a triblock carbonate-ester-carbonate copolymer with carbonate linkages between the arylate block and organic carbonate end-blocks. Copolyestercarbonates with at least one carbonate linkage between an arylate block and an organic carbonate block are typically prepared from 1,3-dihydroxybenzene arylate-containing oligomers containing at least one and in some aspects preferably two hydroxy-terminal sites (hereinafter sometimes referred to as hydroxy-terminated polyester intermediate).

In another aspect the copolyestercarbonate comprises arylate blocks linked by carbonate linkages as shown in Formula V: 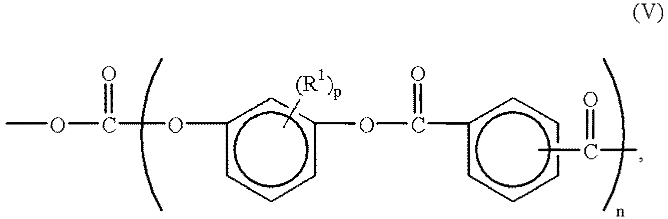 wherein R¹, p, and n are as previously defined, and the arylate structural units are as described for Formula I. Copolyestercarbonates comprising Formula V may arise from reaction of hydroxy-terminated polyester intermediate with a carbonate precursor in the substantial absence of any dihydroxy compound different from the hydroxy-terminated polyester intermediate.

In the copolyestercarbonates according to aspects of the present disclosure the distribution of the blocks may be such as to provide a copolymer having any desired weight proportion of arylate blocks in relation to carbonate blocks. In general, copolymers containing about 10-99% by weight arylate blocks are preferred.

In further aspects the polymeric block copolyestercarbonate may be any of those copolyestercarbonates described in U.S. Patent No. 6,143,839, the disclosure of which is incorporated herein by this reference in its entirety, provided that the polymeric block copolyestercarbonate has a glass transition temperature of at least 130 °C and has a sheet resistance of less than 20 Ω/sq as described herein.

In some aspects the polymeric block copolyestercarbonate has a glass transition temperature of at least 133 °C, or at least 135 °C. In a particular aspect the polymeric block copolyestercarbonate has a glass transition temperature of about 137 °C.

One particular polymeric block copolyestercarbonate suitable for use in aspects of the disclosure is Lexan® SLX2531T, available from SABIC.

In some aspects the polymeric block copolyestercarbonate is inherently ultraviolet resistant. In other words, the polymeric block copolyestercarbonate includes in its structure a moiety that blocks ultraviolet radiation and protects the polymer from embrittlement, cracking and other forms of degradation common to polymers when exposed to ultraviolet radiation.

In certain aspects the electrically-conductive material and/or the polymeric block copolyestercarbonate is transparent. The transparency or translucency of a given object or medium (e.g., electrically-conductive material, polymeric substrate, conductive nanostructured material, conductive microstructured material, etc.) can be determined by measuring the total transmittance of incident light through the object/medium. The reflectivity, translucency, or transparency of an electrically-conductive material produced by the process of the present disclosure can be affected by the amount of conductive nanostructured or microstructured material applied on the substrate's surface. By way of example, the total transmittance of incident light through the produced conductive material can be 0%, 10%, 20%, 30%, 40%, 50%, 60% 70%, 80%, 90%, or more, and this can be adjusted or tuned as desired based on the amount of conductive nanostructured or microstructured material used in the process of the present disclosure. Further, and in instances where the substrate is transparent, additional conductive nanostructured or microstructured material may be used to create a sufficient reflectivity when compared with substrates that are translucent or that are opaque.

In particular aspects transparency may be described in terms of the amount of light in the visible spectrum of light that is transmitted through the polymeric block copolyestercarbonate, where the visible spectrum of light is generally considered the wavelength range of about 400 to about 700 nanometers (nm). Thus, in some aspects the electrically-conductive material and/or the polymeric block copolyestercarbonate has a light transmission of greater than 80% at a wavelength of 400 to 700 nm. In further aspects the electrically-conductive material and/or the polymeric block copolyestercarbonate has a light transmission of greater than 85% at a wavelength of 400 to 700 nm, or the electrically-conductive material and/or the polymeric block copolyestercarbonate has a light transmission of greater than 90% at a wavelength of 400 to 700 nm.

In further aspects the electrically-conductive material and/or polymeric block copolyestercarbonate has good chemical resistance properties. Chemical resistance may include one or more of resistance to grease, oil, acidic compounds (including weak and/or dilute acidic compounds), aromatic compounds, alcohols and alkali compounds. The Lexan@ SLX2531T polymer described herein has good resistance to grease, oil, weak/dilute acidic compounds and aromatic compounds and moderate resistance to alcohols and alkali compounds.

As noted, an electrically-conductive material according to aspects of the disclosure includes a polymeric substrate and a conductive nanostructured or microstructured material adhered to at least one surface of the polymeric substrate. In some aspects the conductive nanostructured or microstructured material includes silver, gold, copper, nickel, gold-plated silver and combinations thereof. In a particular aspect the conductive nanostructured or microstructured material includes silver.

The conductive nanostructured or microstructured material may be in any suitable form. In particular aspects the conductive nanostructured or microstructured material is in the form of metal nanowires and/or other conductive particles having high aspect ratios (e.g., higher than 10). Non-limiting examples of non-metallic nanowires suitable for aspects of the disclosure include carbon nanotubes (CNTs), metal oxide nanowires, conductive polymer fibers and combinations thereof. In a particular aspect the conductive nanostructured or microstructured material is in the form of nanowires.

"Conductive nanostructured material" may refer to a network material/layer that comprises nanostructures that is capable of conducting electricity. "Conductive microstructured material" refers to a network material/layer that comprises microstructures that is capable of conducting electricity. Since conductivity is achieved by electrical charge percolating from one nanostructure/microstructure to another, a sufficient amount of nano/micro structures should be present in the conductive layer to reach an electrical percolation threshold and become conductive. The surface conductivity of the conductive nanostructure/microstructure layer is inversely proportional to its surface resistivity, sometimes referred to as sheet resistance, which can be measured by known methods in the art. Further, although the term "conductive nanostructured or microstructured material" is used herein, it will be recognized that the use of nanostructured materials and microstructured materials is not mutually exclusive, and that electrically-conductive materials according to aspects of the disclosure may include both nanostructured materials and microstructured materials.

In certain aspects the conductive nanostructured or microstructured material is adhered to at least one surface of the polymeric substrate by spray coating it onto the polymeric substrate in accordance with the methods described herein. The at least one surface of the electrically-conductive material may be a substantially smooth surface in some aspects. In some aspects "smooth" means that the surface has surface height variations of less than about 500 nm. In further aspects "smooth" means that the surface has surface height variations of less than about 400 nm, or that the surface has surface height variations of less than about 300 nm, or that the surface has surface height variations of less than about 200 nm, or that the surface has surface height variations of less than about 100 nm, or that the surface has surface height variations of less than about 50 nm. In particular aspects "smooth" means that the surface has surface height variations ranging from about 5 nm to about 50 nm.

### Methods for Making an Electrically-Conductive Material

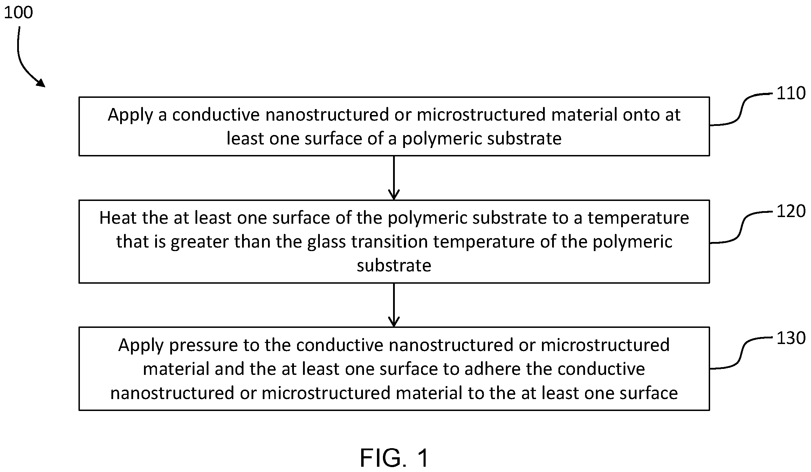

Aspects of the disclosure further related to methods for making an electrically-conductive material and with reference to FIG. 1 include: applying a conductive nanostructured or microstructured material onto at least one surface of a polymeric substrate, the polymeric substrate having a glass transition temperature of at least 130 °C; heating the at least one surface of the polymeric substrate to a temperature that is greater than the glass transition temperature of the polymeric substrate; and applying pressure to the conductive nanostructured or microstructured material and the at least one surface to adhere the conductive nanostructured or microstructured material to the at least one surface. The polymeric substrate comprises a polymeric block copolyestercarbonate derived from resorcinol or alkylresorcinol isophthalate-terepthalate and has a sheet resistance of less than 20 Ω/sq.

Specific methods of making the electrically-conductive material include those described in U.S. Patent Publication No. 2015/0037517 ("517 Publication"), published February 5, 2015. With specific reference to FIG. 1, one aspect of the method 100 includes, at step 110, applying a conductive nanostructured or microstructured material onto at least one surface of a polymeric substrate. In some aspects the conductive nanostructured or microstructured material includes silver, gold, copper, nickel, gold-plated silver and combinations thereof. In a particular aspect the conductive nanostructured or microstructured material includes silver.

The conductive nanostructured or microstructured material may be in any suitable form. In particular aspects the conductive nanostructured or microstructured material is in the form of metal nanowires and/or other conductive particles having high aspect ratios (e.g., higher than 10). Non-limiting examples of non-metallic nanowires suitable for aspects of the disclosure include carbon nanotubes (CNTs), metal oxide nanowires, conductive polymer fibers and combinations thereof. In a particular aspect the conductive nanostructured or microstructured material is in the form of nanowires.

The conductive nanostructured or microstructured material may be applied to the at least one surface by any suitable method, including but not limited to spray coating, ultrasonic spray coating, roll-to-roll coating, ink jet printing, screen printing, drop casting, spin coating, dip coating, Mayer rod coating, gravure coating, slot die coating, doctor blade coating or a combination thereof. In a particular aspect, the step of applying the conductive nanostructured or microstructured material comprises spray coating the conductive nanostructured or microstructured material onto the at least one surface.

Aspects of the method further include, at step 120, heating the at least one surface of the polymeric substrate to a temperature that is greater than the glass transition temperature of the polymeric substrate. In some aspects the polymeric block copolyestercarbonate has a glass transition temperature of at least 130 °C. In further aspects the polymeric block copolyestercarbonate has a glass transition temperature of at least 133 °C, or at least 135 °C. In a particular aspect the polymeric block copolyestercarbonate has a glass transition temperature of about 137 °C.

The method may further include, at step 130, applying pressure to the conductive nanostructured or microstructured material and the at least one surface to adhere the conductive nanostructured or microstructured material to the at least one surface. Pressure can be applied to the conductive nanostructured or microstructured material and the at least one surface by any suitable pressure source, including but not limited to (as explained in the 517 Publication), a roller such as a metallic roller, a ceramic roller, a plastic roller or a rubber roller. Further, the pressure and speed applied by the roller (if used) can be sufficient to cause the conductive nanostructured or microstructured material to adhere to the at least one surface of the polymeric substrate. Purely exemplary pressures range from, e.g., 25 to 300 pounds per square inch (psi) and speeds range from, e.g., 0.1 centimeters per second (cm/s) to 10 cm/s.

In one aspect, the step of applying pressure to the conductive nanostructured or microstructured material and the at least one surface causes the at least one surface to be substantially smooth (as that term is described herein).

The polymeric block copolyestercarbonate comprises any one or more of those materials described herein. Further, the polymeric block copolyestercarbonate and may have any of the properties described above, including but not limited to one or more of inherent ultraviolet resistance, transparency, light transmission properties, chemical resistance and/or sheet resistance.

Various combinations of elements of this disclosure are encompassed by this disclosure, e.g., combinations of elements from dependent claims that depend upon the same independent claim.

### Aspects of the Disclosure

In various aspects, the present disclosure pertains to and includes at least the following aspects.
Aspect 1: An electrically-conductive material comprising, consisting of or consisting essentially of: a polymeric substrate and a conductive nanostructured or microstructured material adhered to at least one surface of the polymeric substrate, wherein
   the polymeric substrate comprises a polymeric block copolyestercarbonate derived from resorcinol or alkylresorcinol isophthalate-terepthalate,
   the polymeric block copolyestercarbonate has a glass transition temperature of at least 130 degrees Celsius (°C), and
   the polymeric block copolyestercarbonate has a sheet resistance of less than 20 ohms (Ω) per square (sq).
Aspect 2: The electrically-conductive material according to Aspect 1, wherein the polymeric block copolyestercarbonate is inherently ultraviolet resistant.
Aspect 3: The electrically-conductive material according to Aspect 1 or 2, wherein the electrically-conductive material is transparent.
Aspect 4: The electrically-conductive material according to any of Aspects 1 to 3, wherein the electrically-conductive material has a light transmission of greater than 80% at a wavelength of 400 to 700 nanometers (nm).
Aspect 5: The electrically-conductive material according to any of Aspects 1 to 4, wherein the polymeric block copolyestercarbonate has good chemical resistance properties.
Aspect 6: The electrically-conductive material according to any of Aspects 1 to 5, wherein the conductive nanostructured or microstructured material comprises silver, gold, copper, nickel, gold-plated silver and combinations thereof.
Aspect 7: The electrically-conductive material according to Aspect 6, wherein the conductive nanostructured or microstructured material comprises silver.
Aspect 8: The electrically-conductive material according to any of Aspects 1 to 7, wherein the polymeric block copolyestercarbonate has a glass transition temperature of about 137 °C.
Aspect 9: The electrically-conductive material according to any of Aspects 1 to 8, wherein the conductive nanostructured or microstructured material is spray coated onto the polymeric substrate.
Aspect 10: The electrically-conductive material according to any of Aspects 1 to 9, wherein the at least one surface is a substantially smooth surface.
Aspect 11: A method for making an electrically-conductive material comprising, consisting of, or consisting essentially of:
   applying a conductive nanostructured or microstructured material onto at least one surface of a polymeric substrate, the polymeric substrate having a glass transition temperature of at least 130 °C;
   heating the at least one surface of the polymeric substrate to a temperature that is greater than the glass transition temperature of the polymeric substrate; and
   applying pressure to the conductive nanostructured or microstructured material and the at least one surface to adhere the conductive nanostructured or microstructured material to the at least one surface,
   wherein the polymeric substrate comprises a polymeric block copolyestercarbonate derived from resorcinol or alkylresorcinol isophthalate-terepthalate and has a sheet resistance of less than 20 ohms (Ω) per square (sq).
Aspect 12: The method according to Aspect 11, wherein the step of applying the conductive nanostructured or microstructured material comprises spray coating, ultrasonic spray coating, roll-to-roll coating, ink jet printing, screen printing, drop casting, spin coating, dip coating, Mayer rod coating, gravure coating, slot die coating, or doctor blade coating the conductive nanostructured or microstructured material onto the at least one surface.
Aspect 13: The method according to Aspect 12, wherein the step of applying the conductive nanostructured or microstructured material comprises spray coating the conductive nanostructured or microstructured material onto the at least one surface.
Aspect 14: The method according to any of Aspects 11 to 13, wherein the polymeric block copolyestercarbonate is inherently ultraviolet resistant.
Aspect 15: The method according to any of Aspects 11 to 14, wherein the electrically-conductive material is transparent.
Aspect 16: The method according to any of Aspects 11 to 15, wherein the electrically-conductive material has a light transmission of greater than 80% at a wavelength of 400 to 700 nanometers (nm).
Aspect 17: The method according to any of Aspects 11 to 16, wherein the polymeric block copolyestercarbonate has good chemical resistance properties.
Aspect 18: The method according to any of Aspects 11 to 17, wherein the conductive nanostructured or microstructured material comprises silver, gold, copper, nickel, gold-plated silver and combinations thereof.
Aspect 19: The method according to Aspect 18, wherein the conductive nanostructured or microstructured material comprises silver.
Aspect 20: The method according to any of Aspects 11 to 19, wherein the step of applying pressure to the conductive nanostructured or microstructured material and the at least one surface causes the at least one surface to be substantially smooth.

### EXAMPLES

The following examples are put forth so as to provide those of ordinary skill in the art with a complete disclosure and description of how the compounds, compositions, articles, devices and/or methods claimed herein are made and evaluated, and are intended to be purely exemplary and are not intended to limit the disclosure. Efforts have been made to ensure accuracy with respect to numbers (e.g., amounts, temperature, etc.), but some errors and deviations should be accounted for. Unless indicated otherwise, parts are parts by weight, temperature is in °C or is at ambient temperature, and pressure is at or near atmospheric. Unless indicated otherwise, percentages referring to composition are in terms of wt%.

There are numerous variations and combinations of reaction conditions, e.g., component concentrations, desired solvents, solvent mixtures, temperatures, pressures and other reaction ranges and conditions that can be used to optimize the product purity and yield obtained from the described process. Only reasonable and routine experimentation will be required to optimize such process conditions.

### EXAMPLE 1

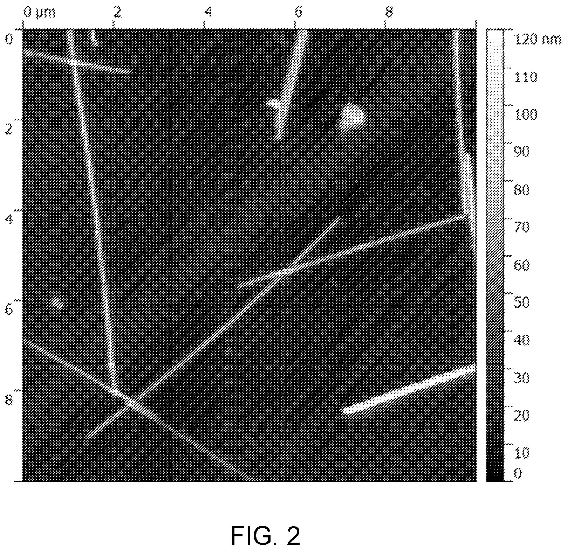

Silver nanowires were applied to a surface of a polymeric block copolyestercarbonate derived from resorcinol or alkylresorcinol isophthalate-terepthalate according to methods described herein. The specific copolyestercarbonate was Lexan® SLX2531T polymer. FIG. 2 is a nanometer-scale image of the surface of the material. The nanowires are visible as bright lines on the darker surface.

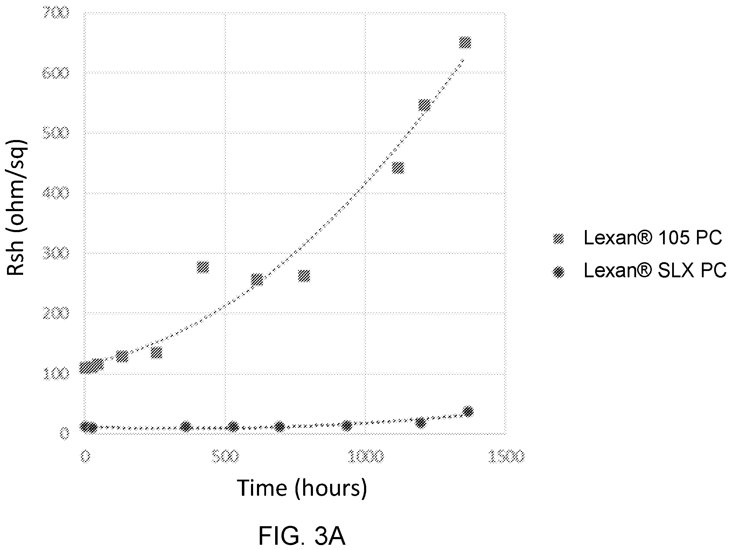

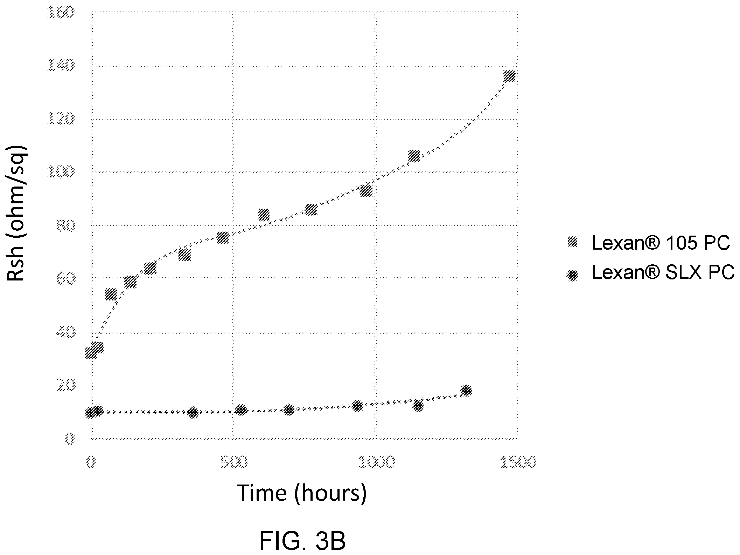

FIGS. 3A and 3B show graphs of sheet resistance vs. time for this material (labeled as "Lexan® SLX PC") as compared to a known Lexan@ polycarbonate (Lexan® 105 polycarbonate). As shown in the figures, the Lexan® SLX2531T polymer had a sheet resistance 15 ± 2 Ω/sq across all measured time periods, in contrast to the prior art Lexan® polycarbonate, which had a substantially higher sheet resistance. Further, the Lexan® SLX253 1T polymer had a light transmission of 82% in the visible range of the spectrum (i.e., between 400 nm and 700 nm).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or nonvolatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. The scope of the disclosure should be determined with reference to the appended claims.

## Claims

1. An electrically-conductive material suitable for a roll-to-roll manufacturing process comprising a polymeric substrate and a conductive nanostructured or microstructured material adhered to at least one surface of the polymeric substrate, **characterized in that**:
the polymeric substrate comprises a polymeric block copolyestercarbonate derived from resorcinol or alkylresorcinol isophthalate-terepthalate;
the polymeric block copolyestercarbonate has a glass transition temperature of at least 130 degrees Celsius (°C); and
the polymeric block copolyestercarbonate has a sheet resistance of less than 20 ohms (Ω) per square (sq).

2. The electrically-conductive material according to claim 1, wherein the polymeric block copolyestercarbonate is inherently ultraviolet resistant.

3. The electrically-conductive material according to claim 1 or 2, wherein the electrically-conductive material is transparent.

4. The electrically-conductive material according to any of claims 1 to 3, wherein the electrically-conductive material has a light transmission of greater than 80% at a wavelength of 400 to 700 nanometers (nm).

5. The electrically-conductive material according to any of claims 1 to 4, wherein the conductive nanostructured or microstructured material comprises silver, gold, copper, nickel, gold-plated silver and combinations thereof.

6. The electrically-conductive material according to claim 5, wherein the conductive nanostructured or microstructured material comprises silver.

7. The electrically-conductive material according to any of claims 1 to 6, wherein the polymeric block copolyestercarbonate has a glass transition temperature of 137 °C.

8. The electrically-conductive material according to any of claims 1 to 7, wherein the conductive nanostructured or microstructured material is spray coated onto the polymeric substrate.

9. The electrically-conductive material according to any of claims 1 to 8, wherein the at least one surface is a substantially smooth surface.

10. A method (100) for making an electrically-conductive material suitable for a roll-to-roll manufacturing process comprising:
applying a conductive nanostructured or microstructured material onto at least one surface of a polymeric substrate (110);
heating the at least one surface of the polymeric substrate to a temperature that is greater than a glass transition temperature of the polymeric substrate (120); and
applying pressure to the conductive nanostructured or microstructured material and the at least one surface to adhere the conductive nanostructured or microstructured material to the at least one surface (130), **characterized in that**:
the polymeric substrate comprises a polymeric block copolyestercarbonate derived from resorcinol or alkylresorcinol isophthalate-terepthalate and has a sheet resistance of less than 20 ohms (Ω) per square (sq), and
the polymeric substrate has a glass transition temperature of at least 130 °C.

11. The method according to claim 10, wherein the step of applying the conductive nanostructured or microstructured material (110) comprises spray coating, ultrasonic spray coating, roll-to-roll coating, ink jet printing, screen printing, drop casting, spin coating, dip coating, Mayer rod coating, gravure coating, slot die coating, or doctor blade coating the conductive nanostructured or microstructured material onto the at least one surface.

12. The method according to claim 11, wherein the step of applying the conductive nanostructured or microstructured material (110) comprises spray coating the conductive nanostructured or microstructured material onto the at least one surface.

13. The method according to any of claims 10 to 12, wherein the polymeric block copolyestercarbonate is inherently ultraviolet resistant.

14. The method according to any of claims 10 to 13, wherein the electrically-conductive material is transparent.

## Patentansprüche

1. Elektrisch leitfähiges Material, das für eine Rolle-zu-Rolle-Herstellungsmethode geeignet ist, umfassend ein polymeres Substrat und ein leitfähiges nanostrukturiertes oder mikrostrukturiertes Material, das an mindestens einer Oberfläche des polymeren Substrats haftet, **dadurch gekennzeichnet, dass**:
das polymere Substrat ein polymeres Blockcopolyestercarbonat umfasst, das von Resorcin oder Alkylresorcin-Isophthalat-Terephthalat abgeleitet ist;
das polymere Blockcopolyestercarbonat eine Glasübergangstemperatur von mindestens 130 Grad Celsius (°C) aufweist; und
das polymere Blockcopolyestercarbonat einen Schichtwiderstand von weniger als 20 Ohm pro Quadrat aufweist.

2. Elektrisch leitfähiges Material nach Anspruch 1, wobei das polymere Blockcopolyestercarbonat inhärent ultraviolettbeständig ist.

3. Elektrisch leitfähiges Material nach Anspruch 1 oder 2, wobei das elektrisch leitfähige Material transparent ist.

4. Elektrisch leitfähiges Material nach einem der Ansprüche 1 bis 3, wobei das elektrisch leitfähige Material eine Lichttransmission von mehr als 80 % bei einer Wellenlänge von 400 bis 700 Nanometern (nm) aufweist.

5. Elektrisch leitfähiges Material nach einem der Ansprüche 1 bis 4, wobei das leitfähige nanostrukturierte oder mikrostrukturierte Material Silber, Gold, Kupfer, Nickel, vergoldetes Silber und Kombinationen davon umfasst.

6. Elektrisch leitfähiges Material nach Anspruch 5, wobei das leitfähige nanostrukturierte oder mikrostrukturierte Material Silber umfasst.

7. Elektrisch leitfähiges Material nach einem der Ansprüche 1 bis 6, wobei das polymere Blockcopolyestercarbonat eine Glasübergangstemperatur von 137 °C aufweist.

8. Elektrisch leitfähiges Material nach einem der Ansprüche 1 bis 7, wobei das leitfähige nanostrukturierte oder mikrostrukturierte Material auf das polymere Substrat aufgesprüht wird.

9. Elektrisch leitfähiges Material nach einem der Ansprüche 1 bis 8, wobei die mindestens eine Oberfläche eine im Wesentlichen glatte Oberfläche ist.

10. Methode (100) zur Herstellung eines elektrisch leitenden Materials, das für eine Rolle-zu-Rolle-Herstellungsmethode geeignet ist, umfassend:
Aufbringen eines leitfähigen nanostrukturierten oder mikrostrukturierten Materials auf mindestens eine Oberfläche eines polymeren Substrats (110);
Erhitzen der mindestens einen Oberfläche des polymeren Substrats auf eine Temperatur, die größer ist als eine Glasübergangstemperatur des polymeren Substrats (120); und
Ausüben von Druck auf das leitfähige nanostrukturierte oder mikrostrukturierte Material und die mindestens eine Oberfläche, um das leitfähige nanostrukturierte oder mikrostrukturierte Material an der mindestens einen Oberfläche (130) anzukleben, **dadurch gekennzeichnet, dass**:
das polymere Substrat ein von Resorcin oder Alkylresorcin-Isophthalat-Terephthalat abgeleitetes polymeres Blockcopolyestercarbonat umfasst und einen Schichtwiderstand von weniger als 20 Ohm pro Quadrat aufweist, und
das polymere Substrat eine Glasübergangstemperatur von mindestens 130 °C aufweist.

11. Methode nach Anspruch 10, wobei der Schritt des Aufbringens des leitfähigen nanostrukturierten oder mikrostrukturierten Materials (110) ein Aufsprühen, Ultraschall-Aufsprühen, Rolle-zu-Rolle-Beschichten, Tintenstrahldrucken, Siebdrucken, Tropfengießen, Schleuderbeschichten, Tauchbeschichten, Mayer-Stabbeschichten, Gravurbeschichten, Schlitzdüsenbeschichten oder Rakelbeschichten des leitfähigen nanostrukturierten oder mikrostrukturierten Materials auf die mindestens eine Oberfläche umfasst.

12. Methode nach Anspruch 11, wobei der Schritt des Aufbringens des leitfähigen nanostrukturierten oder mikrostrukturierten Materials (110) das Aufsprühen des leitfähigen nanostrukturierten oder mikrostrukturierten Materials auf die mindestens eine Oberfläche umfasst.

13. Methode nach einem der Ansprüche 10 bis 12, wobei das polymere Blockcopolyestercarbonat inhärent ultraviolettbeständig ist.

14. Methode nach einem der Ansprüche 10 bis 13, wobei das elektrisch leitfähige Material transparent ist.

## Revendications

1. Matériau électriquement conducteur approprié pour un processus de fabrication rouleau à rouleau comprenant un substrat polymère et un matériau conducteur nanostructuré ou microstructuré adhérant à au moins une surface du substrat polymère, **caractérisé en ce que** :
le substrat polymère comprend un copolyester carbonate polymère séquencé dérivé de résorcinol ou d'isophtalate-téréphtalate d'alkylrésorcinol ;
le carbonate de copolyester bloc polymère a une température de transition vitreuse d'au moins 130 degrés Celsius (° C) ; et
le carbonate de copolyester bloc polymère a une résistance de feuille inférieure à 20 ohms par carré.

2. Matériau électriquement conducteur selon la revendication 1, dans lequel le carbonate de copolyester bloc polymère est intrinsèquement résistant aux ultraviolets.

3. Matériau électriquement conducteur selon la revendication 1 ou 2, dans lequel le matériau électriquement conducteur est transparent.

4. Matériau électriquement conducteur selon l'une quelconque des revendications 1 à 3, dans lequel le matériau électriquement conducteur a une transmission lumineuse supérieure à 80% à une longueur d'onde de 400 à 700 nanomètres (nm).

5. Matériau électriquement conducteur selon l'une quelconque des revendications 1 à 4, dans lequel le matériau conducteur nanostructuré ou microstructuré comprend de l'argent, de l'or, du cuivre, du nickel, de l'argent plaqué or et des combinaisons de ceux-ci.

6. Matériau électriquement conducteur selon la revendication 5, dans lequel le matériau conducteur nanostructuré ou microstructuré comprend de l'argent.

7. Matériau électriquement conducteur selon l'une quelconque des revendications 1 à 6, dans lequel le carbonate de copolyester séquencé polymère a une température de transition vitreuse de 137 ° C.

8. Matériau électriquement conducteur selon l'une quelconque des revendications 1 à 7, dans lequel le matériau conducteur nanostructuré ou micro-structuré est appliqué par pulvérisation sur le substrat polymère.

9. Matériau électriquement conducteur selon l'une quelconque des revendications 1 à 8, dans lequel au moins une surface est une surface sensiblement lisse.

10. Méthode (100) pour fabriquer un matériau électriquement conducteur approprié pour un processus de fabrication rouleau à rouleau comprenant :
appliquer un matériau conducteur nanostructuré ou microstructuré sur au moins une surface d'un substrat polymère (110) ;
chauffer au moins une surface du substrat polymère à une température qui est supérieure à une température de transition vitreuse du substrat polymère (120) ; et
appliquer une pression au matériau conducteur nanostructuré ou microstructuré et à la au moins une surface pour faire adhérer le matériau conducteur nanostructuré ou microstructuré à la au moins une surface (130), **caractérisé en ce que** :
le substrat polymère comprend un copolyester carbonate polymère séquencé dérivé de résorcinol ou d'isophtalate-téréphtalate d'alkylrésorcinol et a une résistance de feuille inférieure à 20 ohms par carré, et
le substrat polymère a une température de transition vitreuse d'au moins 130 °C.

11. Méthode selon la revendication 10, dans laquelle l'étape d'application du matériau conducteur nanostructuré ou microstructuré (110) comprend le revêtement par pulvérisation, le revêtement par pulvérisation ultrasonique, le revêtement rouleau à rouleau, l'impression à jet d'encre, la sérigraphie, la coulée en goutte, le revêtement par centrifugation, l'immersion, revêtement, revêtement de tige de Mayer, revêtement de gravure, revêtement de matrice à fente, ou revêtement de lame de docteur le matériau conducteur nanostructuré ou microstructuré sur la au moins une surface.

12. Méthode selon la revendication 11, dans laquelle l'étape d'application du matériau conducteur nanostructuré ou microstructuré (110) comprend le revêtement par pulvérisation du matériau conducteur nanostructuré ou microstructuré sur au moins une surface.

13. Méthode selon l'une quelconque des revendications 10 à 12, dans laquelle le carbonate de copolyester bloc polymère est intrinsèquement résistant aux ultraviolets.

14. Méthode selon l'une quelconque des revendications 10 à 13, dans laquelle le matériau électriquement conducteur est transparent.
